# EUROPEAN PATENT SPECIFICATION

(11) **EP 0 574 186 B1**
(45) Date of publication and mention of the grant of the patent: **17.05.1995**
(21) Application number: 93304331.7
(22) Date of filing: 03.06.1993
(51) Int. Cl.: H01L 29/786

(54) **Thin film transistor and active matrix liquid crystal display device**
Dünnfilmtransistor und Flüssigkristallanzeigevorrichtung mit aktiver Matrix
Transistor à couche mince et dispositif d'affichage à cristaux liquides à matrice active

(30) Priority: 09.06.1992 JP 147859/92
(43) Date of publication of application: 15.12.1993
(73) Proprietor: International Business Machines Corporation, Armonk, N.Y. 10504 (US)
(72) Inventor: Yoshida, Toshihiko, 1-211, Forest-Hills-Miho, Yokohama-shi, Kanagawa-ken (JP); Atsumi, Masakazu, Machida-shi, Tokyo-to (JP); Matsumoto, Takeshi, Fujisawa-shi, Kanagawa-ken (JP)
(74) Representative: Burt, Roger James, Dr.

(56) References cited:
- US-A- 4 609 930
- PATENT ABSTRACTS OF JAPAN vol. 013, no. 393 (E-814)31 August 1989
- PATENT ABSTRACTS OF JAPAN vol. 008, no. 235 (E-275)27 October 1984

## Description

The present invention relates to a thin film transistor and an active matrix liquid crystal display device, and more particularly to a technique for preventing photoelectric leak current generated between source and drain electrodes of a TFT due to incident light.

In general, an active matrix liquid crystal display device having a thin film transistor comprises a plurality of scanning lines (gate lines) and a plurality of signal lines (data lines) disposed in the horizontal and the vertical direction respectively, a thin film transistor (TFT) as a non-linear element at each of the intersections of said scanning and signal lines, one transparent insulating substrate having a transparent display electrode connected to each said thin film transistor, the other transparent insulating substrate having a colour filter, a common electrode, and a reflecting metal black matrix, liquid crystal materials maintained between these two transparent insulating substrates, a light source which radiates light from the back of one transparent insulating substrate toward the other transparent insulating substrate, a device for applying scanning voltage to said scanning lines, and a device for applying signal voltage to said signal lines. The transparent display electrode and the TFT are formed for each liquid crystal cell which forms a pixel element, and optical characteristics for each pixel are modulated according to the magnitude of said scanning and signal voltage.

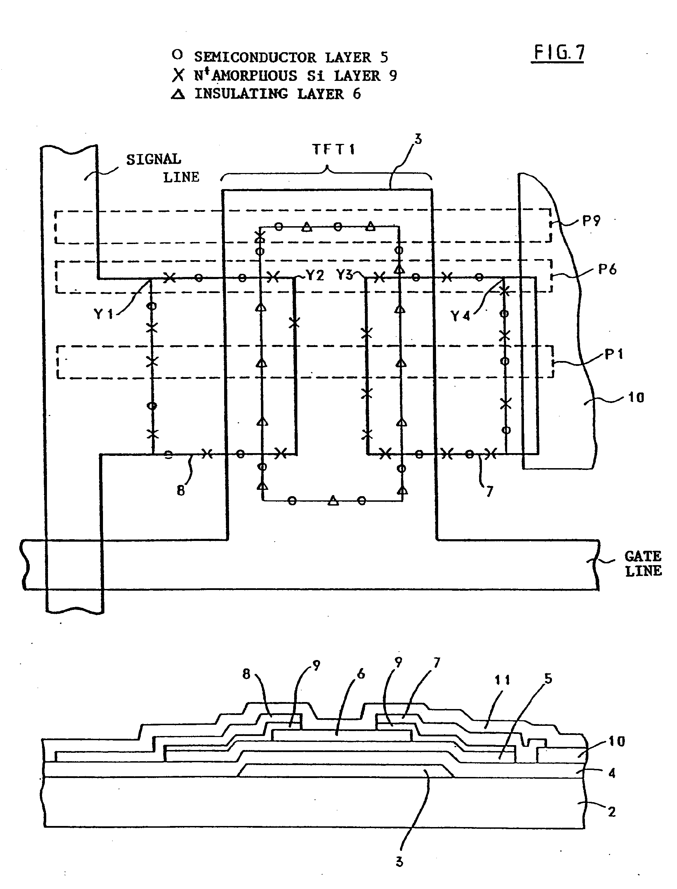

A TFT has been recently proposed in which a channel protective insulating layer is formed on a semiconductor layer serving as a channel so as to prevent the semiconductor layer from being etched. FIG.7 shows an enlarged plan view and a sectional view of such a TFT structure made by the inventors of the present invention. A thin film transistor 1 includes a light shielding gate electrode 3 connected to said scanning lines and formed on an insulating substrate 2 such as a glass substrate, a gate insulator film 4 formed to cover the gate electrode 3, a semiconductor layer 5 formed on the gate insulator film 4 for operating as a channel, a channel protective insulator film 6 formed on a part of the semiconductor layer 5, and a source electrode 7 and a drain electrode 8 connected to said signal lines and electrically contacting said semiconductor layer 5. The source electrode 7 and the drain electrode 8 are light shielding metal layers such as A1 and may also have an N+ amorphous Si layer 9 so as to maintain good ohmic contact with the semiconductor layer 5. Intrinsic amorphous silicon (a-Si), polycrystal silicon (P-Si) and the like are used as materials of the semiconductor layer 5. The channel protective insulator film 6 which determines the length of a channel is needed to prevent the thin semiconductor layer 5 from being etched and is formed by a nitriding film or the like. With typical prior art TFTs, leak current is caused in the intrinsic amorphous silicon semiconductor layer 5 due to incident light from a surface, which is emitted from a light source, passes through liquid crystal materials, reflects on the inner surface of the other transparent insulating substrate, and passes through a transparent nitriding film. This is because holes and electrons are generated when light is projected into an intrinsic amorphous silicon layer. This leak current offers no problem when the TFT is turned on. However, when the leak current flows between source and drain electrodes during the turn off period of the TFT, voltage applied to liquid crystal is changed and consequently display quality is remarkably degraded.

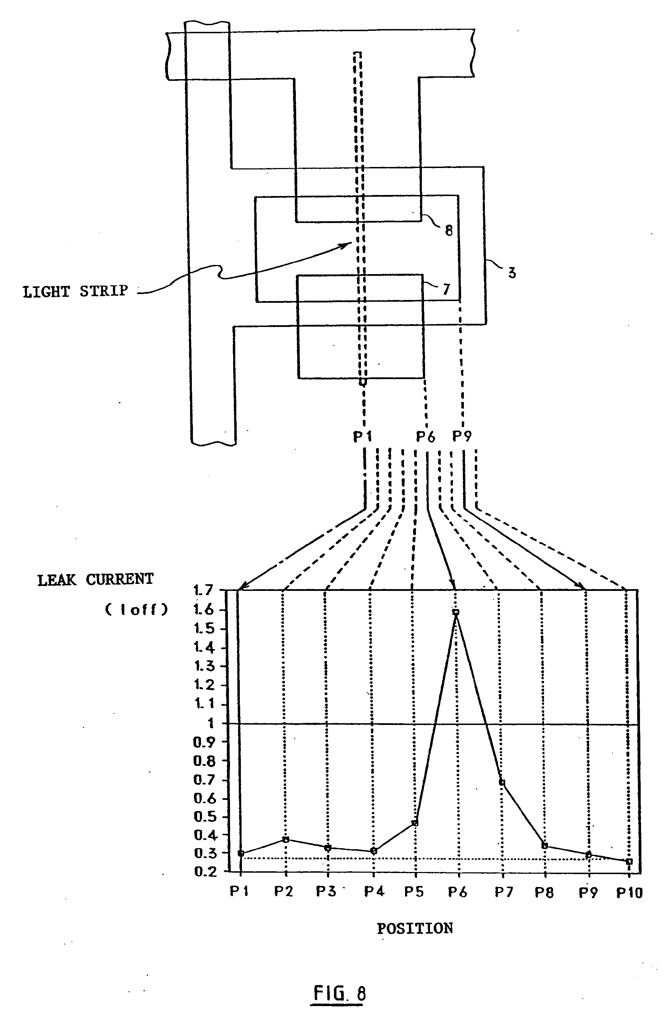

Accordingly, the inventors of the present invention carried out the following experiment to pursue which path in the TFT the leak current flows through. First, the TFT was placed in a black box and current during the turn off period of the TFT (Ioff) was measured. This OFF-state current is about 10⁻¹²A in the TFT of a normal size. Then, the OFF-state current between source and drain electrodes was measured by moving a narrow light strip from a position P1 to a position P10 in order as shown in FIG.8. FIG.8 shows the result of the experiment. An abscissa shows positions and an ordinate shows OFF-state current. A value of the OFF-state current Ioff is represented by a logarithmic value. Further, the value of the OFF-state current is represented by an optional scale since it depends on the intensity of projected light, and Ioff=0 is about 10⁻¹²A and Ioff=1 is about 10⁻¹¹A. The OFF-state current increased by about one digit at a position P6, while the OFF-state current at positions P1 and P9 indicated small values.

In the position P1, since the overlap margin of a mask for forming source and gate electrodes during manufacturing process is needed, the source electrode 7 and the drain electrode 8 extend to cover the channel protective insulator film 6 by a distance of about 2 to 3 »m, which is longer than a hole-electron recombination distance (about 1 »m). Therefore, if a light strip is positioned at the position P1, holes and electrons are not generated in a semiconductor area in which light is shielded by said source electrode 7 and drain electrode 8, and holes and electrons are generated in a semiconductor area in which light is not shielded by said source electrode 7 and drain electrode 8. Since these holes and electrons are recombined and decayed before reaching the source electrode 7 or the drain electrode 8, the leak current between the source electrode 7 and the drain electrode 8 is very low. This very low current is dark current and has no effect on the operation of the TFT.

In the position P9, since a light strip is positioned away from the edges of the source electrode 7 and the drain electrode 8 by a distance which is longer than a distance for recombining holes and electrons, even if holes and electrons are generated in a semiconductor area in which a light strip is projected, these holes and electrons are recombined and decayed before reaching the source electrode 7 and the drain electrode 8, and consequently the leak current between the source electrode 7 and the drain electrode 8 becomes very low. In the position P6, the edges of the source electrode 7 and the drain electrode 8 overlap the edges of the semiconductor layer 5. If a light strip is positioned at the position P6 within a hole-electron recombination distance, holes and electrons which are generated on a vertical wall in a semiconductor area between Y1 and Y2 and on a vertical wall in a semiconductor area between Y3 and Y4 (in which light is not shielded by the source electrode 7 and the drain electrode 8 and the channel protective insulator film 6 is not formed to cover) immediately reach the source electrode 7 and the drain electrode 8. Further, since holes and electrons generated due to incident light exist between Y2 and Y3, a path for the leak current is formed between the drain electrode 8 and the source electrode 7.

Thus, the inventors of the present invention found out that holes and electrons which are generated in an area of the semiconductor layer 5 within a hole-electron recombination distance from the edges of a source electrode and those of a drain electrode overlapping the semiconductor layer 5 respectively, and which reach the source and drain electrodes, contribute to a high leak current formed during the turn off period of the TFT.

A first prior art technique for preventing leak current is to break the projection of light to the overall semiconductor layer. For example, Japanese Published Unexamined Patent Application (PUPA) No.59-117267 which discloses a TFT and an active matrix liquid crystal display device according to the preambles of claims 1 and 5 discloses the formation of an extra light shielding film above a channel region between source and drain electrodes of a TFT, which has a larger area than the region. However this technique has the drawback that yield is decreased, since a process for forming the light shielding film is needed. Further, the number of processes is increased.

A second prior art technique is disclosed in PUPA No.3-85767, in which an extra thick semiconductor layer for recombining and decaying holes and electrons generated due to incident light is provided between a semiconductor layer serving as a channel of a TFT and source and drain electrodes. When the TFT is turned on, a large quantity of electrons is injected into said extra semiconductor layer from the source electrode to form a conducting path. This technique also causes the number of processes to increase and yield to decrease.

An object of the present invention is to provide a device with reduced leak current caused by incident light falling on a semiconductor layer, and hence to improve the display quality of a TFT active matrix liquid crystal display device.

Accordingly the present invention provides a thin film transistor (TFT) including a light shielding gate electrode formed on a transparent insulating substrate, a gate insulating layer formed on the gate electrode, a semiconductor layer formed on the gate insulating layer, and a light shielding source electrode and a light shielding drain electrode formed over and connected to said semiconductor layer to define a channel region in said semiconductor layer, said thin film transistor being characterised by: an insulating layer formed between said semiconductor layer and at least one of said source and drain electrodes, such that said at least one of said source (7) and drain (8) electrodes overlaps said insulating layer (6) by a distance which is longer than a hole-electron recombination distance from all the edges of said at least one of said source and drain electrodes which overlap said semiconductor layer.

Typically the insulating layer extends onto the channel region of the semiconductor layer.

An active matrix liquid crystal display device is formed by two transparent insulating substrates and liquid crystal materials maintained between the two. Viewed from a second aspect the present invention provides an active matrix liquid crystal display device comprising: a first transparent insulating substrate having a plurality of gate lines disposed in a first direction, a plurality of signal lines disposed in a direction intersecting said first direction, and a thin film transistor and display electrode connected to each of the intersections of said gate and signal lines; a second transparent insulating substrate having a common electrode; liquid crystal materials contained between said first and second transparent insulating substrates; means connected to said gate lines for applying gate signals to said gate lines; and means connected to said signal lines for applying data signals to said signal lines; wherein said thin film transistor includes a light shielding gate electrode formed on said first transparent insulating substrate, a gate insulating layer formed on the gate electrode, a semiconductor layer formed on the gate insulating layer, and a light shielding source electrode and a light shielding drain electrode formed over and connected to said semiconductor layer to define a channel region in said semiconductor layer; the active matrix liquid crystal display device being characterised in that: an insulating layer is formed in the thin film transistor between said semiconductor layer and at least one of said source and drain electrodes, such that said at least one of said source (7) and drain (8) electrodes overlaps said insulating layer (6) by a distance which is longer than a hole-electron recombination distance from all the edges of said at least one of said source and drain electrodes which overlap said semiconductor layer.

The present invention has the advantage that it reduces leak current only by changing the conventional construction of components without requiring any new processes.

The present invention will be described further, by way of example only, with reference to an embodiment thereof as illustrated in the accompanying drawings, in which:
FIG.1 shows a plane view and cross sections of a first embodiment of a TFT according to the present invention;
FIG.2 is a diagram showing the circuit of a liquid crystal display cell;
FIG.3 shows the manufacturing process of the TFT according to the preferred embodiment of the present invention;
FIG.4 shows a plane view and cross sections of a second embodiment of the TFT according to the present invention;
FIG.5 is a figure showing a mask used in the process (e) of FIG.3 for manufacturing the TFT of the first embodiment;
FIG.6 is a figure showing a mask used in the process (e) of FIG.3 for manufacturing the TFT of the second embodiment;
FIG.7 shows a plane view and a cross section of a conventional TFT; and
FIG.8 is a graph showing the measurements of leak current of the TFT of FIG.7.

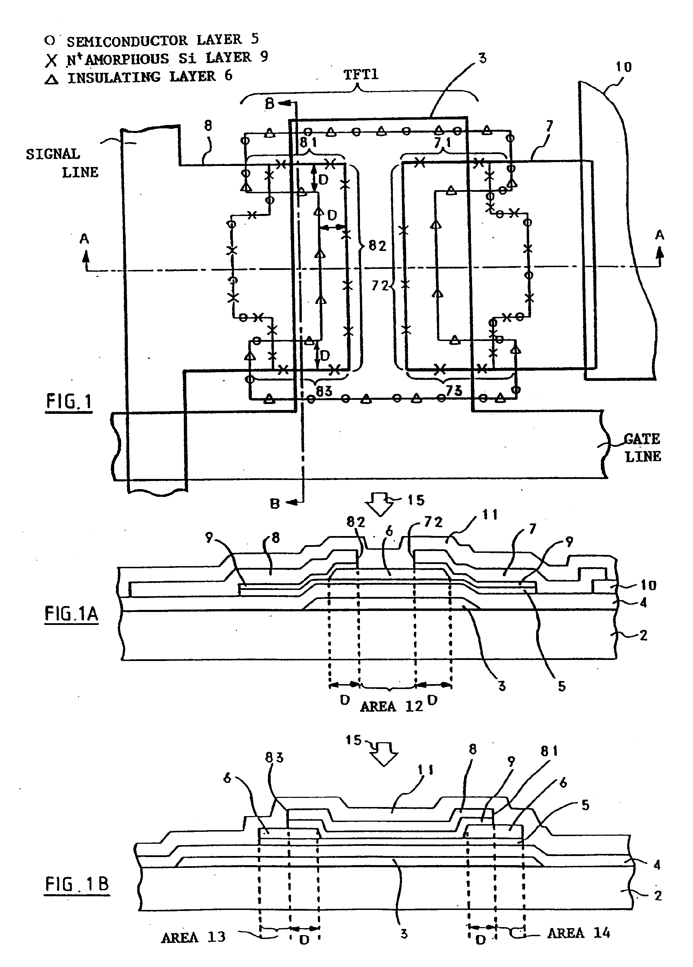

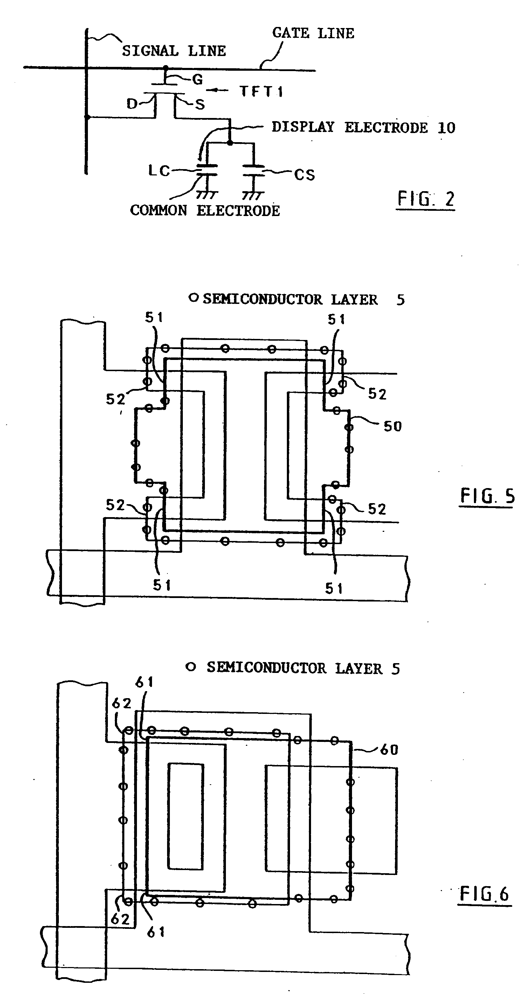

FIG.1 shows a plane view and cross sections of the structure of a first embodiment of a completed liquid crystal display cell according to the present invention. The above-mentioned other transparent insulating substrate is not shown since it is well-known in this field. The liquid crystal display cell is formed at each intersection of the gate and signal lines and has a thin film transistor (TFT) 1 and a display electrode 10. FIG.2 shows the equivalent circuit of the liquid crystal display cell. When a gate pulse is applied to the gate line and a data signal, for example, +V is applied to the signal line, the TFT 1 is turned on, the data signal +V is applied to the display electrode 10, and a display is performed. The data signal +V is stored in a storage capacitor CS for one frame, and consequently the display is maintained for one frame. The storage capacitor CS is not shown in FIG.1. Referring now to the cross-sectional structure of FIG.1, the TFT 1 includes: a light shielding gate electrode 3 formed on the surface of a transparent insulating substrate such as a glass substrate 2; a gate insulating layer 4 such as silicon oxide or silicon nitride; a semiconductor layer 5 such as intrinsic amorphous silicon and polycrystal silicon which forms a channel region of the TFT; a channel protective insulating layer 6 formed on a channel; a source electrode 7 and a drain electrode 8 connected to both ends of the semiconductor layer 5; an N+ amorphous Si layer 9 formed between the source electrode 7 and the drain electrode 8 and the semiconductor layer 5; and a protective layer 11. Provided at the back of the glass substrate 2 in FIG.1 is a light source, in which light is projected upward. The light source is not shown since it is well-known in this field.

In the first embodiment, the insulating layer 6 is formed between the source electrode 7 and the semiconductor layer 5 and between the drain electrode 8 and the semiconductor layer 5 over a distance D, which is longer than a hole-electron recombination distance, from all the edges of the source electrode 7 and the drain electrode 8 of the TFT 1 overlapping the semiconductor layer 5. The edges of the source electrode 7 that overlap the semiconductor layer 5 are 71, 72, and 73, and the edges of the drain electrode 8 overlapping the semiconductor layer 5 are 81, 82, and 83. The edges 82 and 72 are shown in FIG.1A (representing the cross section A-A of FIG.1). When light is projected in the direction of an arrow 15 during the turn off period of the TFT 1, holes and electrons are generated in the area 12 of the semiconductor layer 5 which is not covered by light shielding source and drain electrodes 7 and 8, and they move toward the connection area between the source electrode 7 and the semiconductor layer 5 and the connection area between the drain electrode 8 and the semiconductor layer 5. However, since the insulating layer 6 is formed between the semiconductor layer 5 and the source electrode 7 and between the semiconductor layer 5 and the drain electrode 8 over the distance D between these connection areas and the area 12, the holes and electrons are recombined within the distance D and do not reach the source electrode 7 and the drain electrode 8.

The edges 81 and 83 of the drain electrode 8 are shown in the cross section B-B of FIG.1. When light is projected in the direction of an arrow 15 during the turn off period of the TFT 1, holes and electrons are generated in the areas 13 and 14 of the semiconductor layer 5 which are not covered by the light shielding drain electrode 8, and they move toward the connection area between the drain electrode 8 and the semiconductor layer 5. However, since the insulating layer 6 is formed between the semiconductor layer 5 and the drain electrode 8 over the distance D between the connection area and the areas 13 and 14, the holes and electrons are recombined within the distance D and do not reach the drain electrode 8. The source electrode 7 also has a similar cross section, and the same effect as the above is achieved.

Thus, since the insulating layer 6 is formed between the source electrode 7 and the semiconductor layer 5 and between the drain electrode 8 and the semiconductor layer 5 over a distance D, which is longer than a hole-electron recombination distance, from all the edges, that is, 71, 72, and 73, and also 81, 82, and 83, of the source electrode 7 and the drain electrode 8 of the TFT 1 overlapping the semiconductor layer 5, leak current between the source electrode 7 and the drain electrode 8 during the turn off period of the TFT 1 is prevented. If, for example, the voltage of 10 to 15V is applied to the source and drain electrodes 7 and 8, then since the hole-electron recombination distance is shorter than 1 »m, the distance D is selected to be longer than this distance.

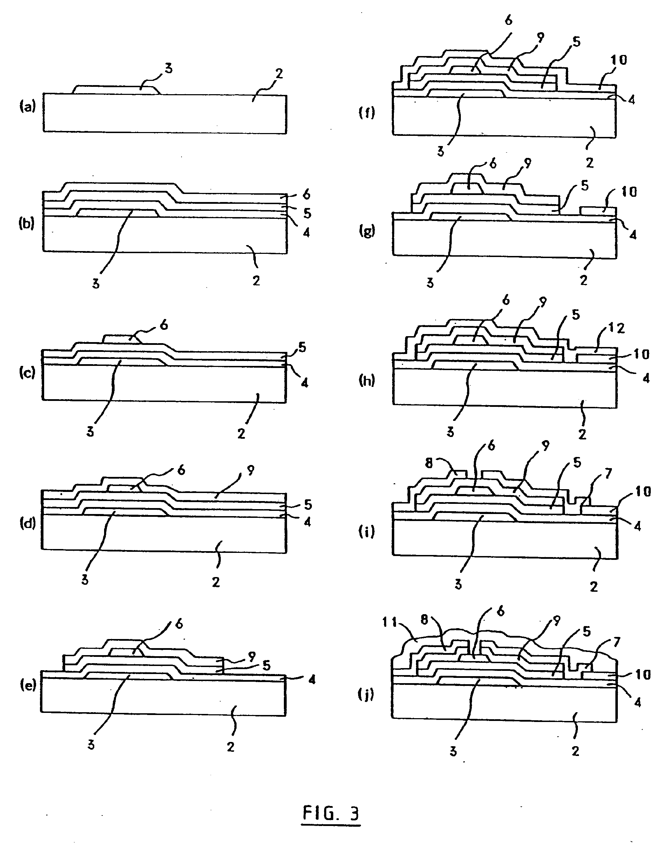

FIG.3 illustrates a process for manufacturing the structure of the first embodiment. FIG.3 shows cross sections taken along the plane of line A-A of FIG.1.

A molybdenum/tantalum (Mo/Ta) alloy is deposited on the glass substrate 2 and is etched using a mask in the shape of the gate lines and the gate electrode of FIG.1, and thereby the gate lines and the gate electrode 3 are formed on the glass substrate (FIG.3(a)). Then, a gate insulator film (oxide film) 4, an intrinsic amorphous silicon (i/a-Si) semiconductor layer 5, and a channel protective insulator film (nitride film) 6 are deposited all over the surface (FIG.3(b)). The channel protective insulating layer 6 is formed by etching using a mask in the shape of the channel protective insulator film 6 of FIG.1 (FIG.3(c)). The N+ amorphous Si layer 9 is deposited all over the surface of the substrate on which said channel protective insulator film 6 is formed (FIG.3(d)). Then, in the process (e) of FIG.3, the N+ amorphous Si layer 9 and the semiconductor layer 5 are formed by etching using a mask 50 shown by the thick line of FIG.5.

The N+ amorphous Si layer 9 is etched in the shape of the mask 50. However, since the channel protective insulating layer 6 exists on the semiconductor layer 5 and functions as a mask, the semiconductor layer 5 is etched as shown in FIG.5. An edge 51 of the mask 50 must not exceed an edge 52 of the channel protective insulating layer 6. If the edge 51 exceeds the edge 52, a conductive path from the semiconductor layer 5 to the electrodes through the N+ amorphous Si layer 9 is formed in the edges of the electrodes, and thereby a path for leak current is created. ITO (indium tin oxide), a material of a transparent display electrode, is deposited all over the surface (FIG.3(f)), and the display electrode 10 is formed by etching using a mask (FIG.3(g)).

Then, aluminum is deposited all over the surface (FIG.3(h)). Said aluminum is etched using a mask, and the source electrode 7 and the drain electrode 8 of FIG.1 are formed (FIG.3(i)). Said display electrode 10 is connected to the TFT through the source electrode 7. Finally, by using said source electrode 7 and drain electrode 8 as a mask, the N+ amorphous Si layer 9 which is not covered by these electrodes is etched (FIG.3(j)), a protective film 11 such as a nitride film is deposited all over the surface, and then an orientation layer (unillustrated) is deposited. In the process of FIG.3(j), since the channel protective insulating layer 6 exists on the semiconductor layer 5, the semiconductor layer 5 is not etched.

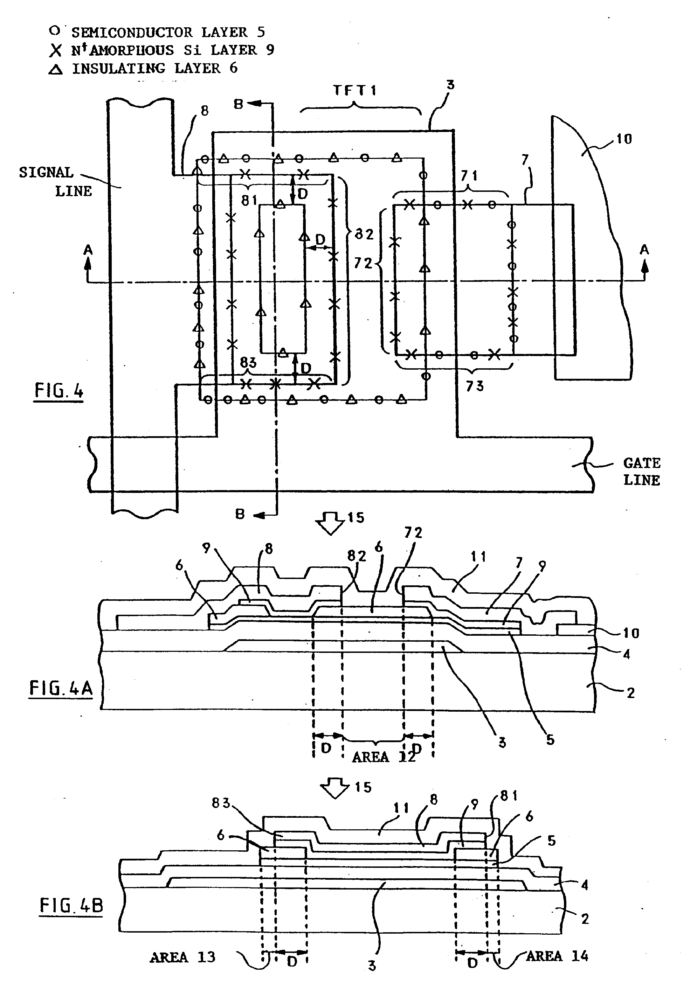

FIG.4 shows a plane view and cross sections of the structure of a second embodiment of a completed liquid crystal display cell according to the present invention. Since the path of leak current has only to be cut in at least one place in order to prevent the leak current caused between a source electrode 7 and a drain electrode 8 during the turn off period of a TFT 1, in the second embodiment the insulating layer 6 is formed between the drain electrode 8 and the semiconductor layer 5 over a distance D, which is longer than a hole-electron recombination distance, from all the edges 81, 82, and 83 of one electrode of the TFT 1, for example, the drain electrode 8 overlapping the semiconductor layer 5. The same reference numbers as FIG.1 are used in FIG.4. When light is projected in the direction of an arrow 15 during the turn off period of the TFT 1, holes and electrons are generated in the areas 12, 13, and 14 of the semiconductor layer 5 adjacent to the drain electrode 8 which are not covered by the light shielding drain electrode 8, and they move toward the connection area between the drain electrode 8 and the semiconductor layer 5.

However, since the insulating layer 6 is formed between the semiconductor layer 5 and the drain electrode 8 over the distance D between the connection area and the areas 12, 13, and 14, the holes and electrons are recombined within the distance D and do not reach the drain electrode 8; therefore leak current is not caused.

A process for manufacturing the structure of the second embodiment will now be described with reference to FIG.3.

In the process (a) of FIG.3, molybdenum/tantalum (Mo/Ta) is deposited on a glass substrate 2, and gate lines and a gate electrode 3 are formed by using a mask in the shape of the gate lines and the gate electrode 3 of FIG.4. In the process (b) of FIG.3, a gate insulating layer (oxide film) 4, an intrinsic amorphous silicon (i/a-Si) semiconductor layer 5, and a channel protective insulating layer (nitride film) 6 are deposited all over the surface. In the process (c) of FIG.3, by using a mask in the shape of the insulating layer 6 of FIG.4, the insulating layer is etched and the channel protective insulating layer 6 of FIG.4 is formed. An aperture is formed in the insulating layer 6 for electrically connecting a drain electrode 8 to the semiconductor layer 5. The cross section of this aperture is shown in figures 4A and 4B showing the sections taken along A-A and B-B of FIG.4. In the process (d) of FIG.3, an N+ amorphous Si layer 9 is deposited.

Then, in the process (e) of FIG.3, the N+ amorphous Si layer 9 and the semiconductor layer 5 are formed by etching using a mask 60 shown by the thick line of FIG.6. The N+ amorphous Si layer 9 is etched in the shape of the mask 60. However, since the channel protective insulating layer 6 exists on the semiconductor layer 5 and functions as a mask, the semiconductor layer 5 is etched as shown in FIG.6. An edge 61 of the mask 60 must not exceed an edge 62 of the channel protective insulating layer 6. If the edge 61 exceeds the edge 62, a conductive path from the semiconductor layer 5 to the drain electrode 8 through the N+ amorphous Si layer 9 is formed in the edge of the drain electrode 8, and thereby a path for leak current is created.

In the process (f) of FIG.3, ITO (indium tin oxide), a material of a transparent display electrode, is deposited all over the surface. In the process (g) of FIG.3, a display electrode 10 is formed by etching using a mask. In the process (h) of FIG.3, aluminum is deposited. In the process (i) of FIG.3, the aluminum is etched by using a mask in the shape of the drain electrode 8 and the source electrode 7 of FIG.4, and the drain electrode 8 and a source electrode 7 are formed. And, in the process (j) of FIG.3, by using the drain electrode 8 and the source electrode 7 as a mask, the N+ amorphous Si layer 9 and the semiconductor layer 5 which are not covered by these electrodes are etched. Then, a protective film 11 such as a nitride film is deposited, and an orientation layer (unillustrated) is deposited.

The source electrode of the second embodiment can be formed by transparent materials such as ITO. In this case, in the process (g) of FIG.3, the source electrode 7 is integrally formed with the display electrode 10. This structure has an advantage that aperture ratio is improved because the display area increases in size.

It will be appreciated by a person skilled in the art that the structure of the present invention may be applied to a reflection type active matrix liquid crystal display device having a reflecting plate instead of a light source.

When an N+ amorphous Si layer is removed from a channel region of a TFT in the process (j) of FIG.3, the insulating layer 6 according to the preferred embodiment of the present invention not only prevents a semiconductor layer 5 serving as this channel from being etched, but also prevents the formation of leak current caused by holes and electrons generated due to incident light.

## Claims

1. A thin film transistor (TFT) including a light shielding gate electrode (3) formed on a transparent insulating substrate (2), a gate insulating layer (4) formed on the gate electrode (3), a semiconductor layer (5) formed on the gate insulating layer (4), and a light shielding source electrode (7) and a light shielding drain electrode (8) formed over and connected to said semiconductor layer (5) to define a channel region in said semiconductor layer is, said thin film transistor being characterised by:
an insulating layer (6) formed between said semiconductor layer (5) and at least one of said source (7) and drain (8) electrodes, such that said at least one of said source (7) and drain (8) electrodes overlaps said insulating layer (6) by a distance which is longer than a hole-electron recombination distance from all the edges of said at least one of said source and drain electrodes which overlap said semiconductor layer.

2. A thin film transistor as claimed in claim 1, wherein the insulating layer is formed between said semiconductor layer and one of said source and drain electrodes.

3. A thin film transistor as claimed in claim 1, wherein the insulating layer is formed between said source electrode and said semiconductor layer, and between said drain electrode and said semiconductor layer.

4. A thin film transistor as claimed in any of claims 1 to 3, wherein said insulating layer (6) extends onto the channel region of said semiconductor layer.

5. An active matrix liquid crystal display device comprising:
a first transparent insulating substrate (2) having a plurality of gate lines disposed in a first direction, a plurality of signal lines disposed in a direction intersecting said first direction, and a thin film transistor (1) and display electrode (10) connected to each of the intersections of said gate and signal lines;
a second transparent insulating substrate having a common electrode;
liquid crystal materials contained between said first and second transparent insulating substrates;
means connected to said gate lines for applying gate signals to said gate lines; and
means connected to said signal lines for applying data signals to said signal lines; wherein
said thin film transistor (1) includes a light shielding gate electrode (3) formed on said first transparent insulating substrate (2), a gate insulating layer (4) formed on the gate electrode (3), a semiconductor layer (5) formed on the gate insulating layer (4), and a light shielding source electrode (7) and a light shielding drain electrode (8) formed over and connected to said semiconductor layer (5) to define a channel region in said semiconductor layer (5);
the active matrix liquid crystal display device being characterised in that:
an insulating layer is formed in the thin film transistor (1) between said semiconductor layer and at least one of said source (7) and drain (8) electrodes, such that said at least one of said source (7) and drain (8) electrodes overlaps said insulating layer (6) by a distance which is longer than a hole-electron recombination distance from all the edges of said at least one of said source and drain electrodes which overlap said semiconductor layer.

6. An active matrix liquid crystal display device as claimed in claim 5, wherein the insulating layer is formed between said semiconductor layer and one of said source and drain electrodes.

7. An active matrix liquid crystal display device as claimed in claim 5 wherein the insulating layer is formed between said source electrode and said semiconductor layer, and between said drain electrode and said semiconductor layer.

8. An active matrix liquid crystal display device as claimed in any of claims 5 to 7, wherein said insulating layer extends onto the channel region of said semiconductor layer.

## Patentansprüche

1. Dünnfilmtransistor (DFT), der eine lichtabschirmende Gate-Elektrode (3), die auf einem transparenten, isolierenden Substrat (2) gebildet wurde, einschließt, eine Gate-Isolierschicht (4) die auf der Gate-Elektrode (3) gebildet wurde, eine Halbleiterschicht (5), die auf der Gate-Isolierschicht (4) gebildet wurde, und eine lichtabschirmende Source-Elektrode (7) und eine lichtabschirmende Drain-Elektrode (8), die über der Halbleiterschicht (5) gebildet wurden und mit ihr verbunden sind, um eine Kanalzone in der Halbleiterschicht (5) zu definieren, wobei der Dünnfilmtransistor gekennzeichnet ist durch:
eine Isolierschicht (6), die zwischen der Halbleiterschicht (5) und zumindest einer der Source- (7) und Drain-Elektroden (8) so gebildet wurde, daß zumindest eine der Source- (7) und Drain-Elektroden (8) die Isolierschicht (6) um eine Strecke überlappt, die größer ist als die Strecke für die Loch-Elektron-Rekombination von allen Rändern der zumindest einen der Source- und Drain-Elektroden aus, die die Halbleiterschicht überlappen.

2. Dünnfilmtransistor nach Anspruch 1, bei dem die Isolierschicht zwischen der Halbleiterschicht und einer der Source- und Drain-Elektroden gebildet wird.

3. Dünnfilmtransistor nach Anspruch 1, bei dem die Isolierschicht zwischen der Source-Elektrode und der Halbleiterschicht und zwischen der Drain-Elektrode und der Halbleiterschicht gebildet wird.

4. Dünnfilmtransistor nach einem der Ansprüche 1 bis 3, bei dem die Isolierschicht (6) sich auf die Kanalzone der Halbleiterschicht erstreckt.

5. Flüssigkristallanzeigevorrichtung mit aktiver Matrix, umfassend:
ein erstes transparentes, isolierendes Substrat (2), das eine Anzahl von Gate-Leitungen, die in einer ersten Richtung angeordnet sind, aufweist, eine Anzahl von Signalleitungen, die in einer Richtung angeordnet sind, die die erste Richtung kreuzt und einen Dünnfilmtransistor (1) und eine Anzeige-Elektrode (10), die mit jedem der Kreuzungspunkte der Gate- und Signalleitungen verbunden sind,
ein zweites transparentes, isolierendes Substrat, das eine gemeinsame Elektrode aufweist,
Flüssigkristallmaterialien, die sich zwischen den ersten und zweiten transparenten, isolierenden Substrates befinden,
Mittel, die mit den Gate-Leitungen verbunden sind, um Gate-Signale an die Gate-Leitungen anzulegen, und
Mittel, die mit den Signalleitungen verbunden sind, um Datensignale an die Signalleitungen anzulegen, wobei
der Dünnfilmtransistor (1) eine lichtabschirmende Gate-Elektrode (3), die auf dem ersten transparenten, isolierenden Substrat (2) gebildet wurde, einschließt, eine Gate-Isolierschicht (4), die auf der Gate-Elektrode (3) gebildet wurde, eine Halbleiterschicht (5), die auf der Gate-Isolierschicht (4) gebildet wurde, und eine lichtabschirmende Source-Elektrode (7) und eine lichtabschirmende Drain-Elektrode (8), die über der Halbleiterschicht (5) gebildet wurden und mit ihr verbunden sind, um eine Kanalzone in der Halbleiterschicht (5) zu definieren,
wobei die Flüssigkristallanzeigevorrichtung mit aktiver Natrix dadurch gekennzeichnet ist, daß:
eine Isolierschicht in dem Dünnfilmtransistor (1) zwischen der Halbleiterschicht und zumindest einer der Source- (7) und Drain-Elektroden (8) so gebildet wird, daß zumindest eine der Source- (7) und Drain-Elektroden (8) die Isölierschicht (6) um eine Strecke überlappt, die größer ist als die Strecke für die Loch-Elektron-Rekombination von all den Rändern der zumindest einen der Source- und Drain-Elektroden aus, die die Halbleiterschicht überlappen.

6. Flüssigkristallanzeigevorrichtung mit aktiver Natrix nach Anspruch 5, bei der die Isolierschicht zwischen der Halbleiterschicht und einer der Source- und Drain-Elektroden gebildet wird.

7. Flüssigkristallanzeigevorrichtung mit aktiver Matrix nach Anspruch 5, bei dem die Isolierschicht zwischen der Source-Elektrode und der Halbleiterschicht gebildet wird und zwischen der Drain-Elektrode und der Halbleiter-schicht.

8. Flüssigkristallanzeigevorrichtung mit aktiver Matrix nach einem der Ansprüche 5 bis 7, bei dem die Isolierschicht sich auf die Kanalzone der Halbleiterschicht erstreckt.

## Revendications

1. Transistor à couches minces (TFT) comprenant une électrode de grille à effet d'écran à la lumière (3) formée sur un substrat isolant transparent (2), une couche d'isolation de grille (4) formée sur l'électrode de grille (3), une couche semiconductrice (5) formée sur la couche d'isolation de grille (4), et une électrode de source à effet d'écran à la lumière (7) et une électrode de drain à effet d'écran à la lumière (8) formées sur et connectées à ladite couche semiconductrice (5) pour définir une zone de canal dans ladite couche semiconductrice (5), ledit transistor à couches minces étant caractérisé en ce qu'il comprend:
une couche isolante (6) formée entre ladite couche semiconductrice (5) et au moins l'une des dites électrodes de source (7) et de drain (8), en sorte que ladite électrode de source (7) ou électrode de drain (8) chevauche ladite couche isolante (6) sur une distance supérieure à la distance de recombinaison des paires électron-trou depuis l'ensemble des bords de ladite électrode de source ou de drain qui chevauche ladite couche semiconductrice.

2. Transistor à couches minces selon la revendication 1, dans lequel la couche isolante est formée entre ladite couche semiconductrice et l'une des dites électrodes de source et de drain.

3. Transistor à couches minces selon la revendication 1, dans lequel la couche isolante est formée entre ladite électrode de source et ladite couche semiconductrice, et entre ladite électrode de drain et ladite couche semiconductrice.

4. Transistor à couches minces selon l'une quelconque des revendications 1 à 3, dans lequel ladite couche isolante (6) s'étend sur la zone de canal de ladite couche semiconductrice.

5. Dispositif d'affichage matriciel actif à cristaux liquides comprenant:
un premier substrat isolant transparent (2) comprenant une pluralité de lignes de grille disposées selon une première direction, un pluralité de lignes de signaux disposées selon une direction entrecoupant ladite première direction, et un transistor à couches minces (1) et une électrode d'affichage (10) connectés à chacune des intersections des dites lignes de grille et de signaux;
un deuxième substrat isolant transparent comprenant une électrode commune;
des cristaux liquides contenus entre les dits premier et deuxième substrats isolants transparents;
un élément connecté aux dites lignes de grille pour appliquer des signaux de grille aux dites lignes de grille; et
un élément connecté aux dites lignes de signaux pour appliquer des signaux de données aux dites lignes de signaux; dans lequel
ledit transistor à couches minces (1) comprend une électrode de grille à effet d'écran à la lumière (3) formée sur ledit premier substrat isolant transparent (2), une couche d'isolation de grille (4) formée sur l'électrode de grille (3), une couche semiconductrice (5) formée sur la couche d'isolation de grille (4), et une électrode de source à effet d'écran à la lumière (7) et une électrode de drain à effet d'écran à la lumière (8) formées sur et connectées à ladite couche semiconductrice (5) pour définir une zone de canal dans ladite couche semiconductrice (5);
le dispositif d'affichage matriciel actif à cristaux liquides étant caractérisé en ce que :
une couche isolante est formée dans le transistor à couches minces (1) entre ladite couche semiconductrice et au moins l'une des dites électrodes de source (7) et de drain (8), en sorte que ladite électrode de source (7) ou électrode de drain (8) chevauche ladite couche isolante (6) sur une distance supérieure à la distance de recombinaison des paires électron-trou depuis l'ensemble des bords de ladite électrode de source ou de drain qui chevauche ladite couche semiconductrice.

6. Dispositif d'affichage matriciel actif à cristaux liquides selon la revendication 5, dans lequel la couche isolante est formée entre ladite couche semiconductrice et l'une des dites électrodes de source et de drain.

7. Dispositif d'affichage matriciel actif à cristaux liquides selon la revendication 5, dans lequel la couche isolante est formée entre ladite électrode de source et ladite couche semiconductrice, et entre ladite électrode de drain et ladite couche semiconductrice.

8. Dispositif d'affichage matriciel actif à cristaux liquides selon l'une quelconque des revendications S à 7, dans lequel ladite couche isolante s'étend sur la zone de canal de ladite couche semiconductrice.
